# EUROPEAN PATENT APPLICATION

(11) **EP 4 227 751 A1**
(43) Date of publication of application: **16.08.2023**
(21) Application number: 23153588.1
(22) Date of filing: 27.01.2023
(51) Int. Cl.: G05B 23/02, G05B 19/05

(54) **MONITORING APPARATUS**

(30) Priority: 14.02.2022 JP 2022020841
(71) Applicant: OMRON Corporation, Kyoto 600-8530 (JP)
(72) Inventor: YAMAMOTO, Naho, Kyoto, 600-8530 (JP); YANO, Keisuke, Kyoto, 600-8530 (JP)
(74) Representative: Isarpatent

(57) **Abstract**

A monitoring apparatus can start measuring a parameter indicating the state of a monitoring target device in an intended operating state without relying on an external trigger. The monitoring apparatus includes a storage that stores a trigger range usable to determine whether measurement of a parameter indicating a state of a monitoring target device is to be started, a calculator that calculates a parameter associated with an operating state of the monitoring target device, and a measurer that starts measuring the parameter indicating the state of the monitoring target device in response to the parameter calculated by the calculator falling within the trigger range.

## Description

### FIELD

The present invention relates to a monitoring apparatus.

### BACKGROUND

In a servo system, a servo driver typically performs servo control over a servomotor in response to commands from a controller such as a programmable logic controller (PLC). Techniques have been developed for detecting an abnormality in such a servomotor (refer to, for example, Patent Literatures 1 and 2).

### CITATION LIST

### PATENT LITERATURE

Patent Literature 1: Japanese Unexamined Patent Application Publication No. 2019-204155
Patent Literature 2: Japanese Unexamined Patent Application Publication No. 2020-035187

### SUMMARY

### TECHNICAL PROBLEM

Under servo control, a servomotor switches its rotation direction, rotational speed, and torque (a combination of the rotation direction, rotational speed, and torque may be hereafter referred to as an operation mode). Although the state of the servomotor is to be measured in an intended operating state, a state parameter (e.g., a current value) indicating the operating state of the servomotor may have a larger change resulting from the operation mode being switched than a change resulting from a change in the operating state. As a trigger to start measuring the state of the servomotor, a change in the state parameter resulting from a change in the operating state of the servomotor may be less noticeable than a change in the state parameter resulting from the operation mode being switched. This may disable the measurement from being started with the servomotor in the intended operating state.

To reduce the likelihood of lower detection accuracy resulting from the operation mode being switched, a trigger to start measuring the state of the servomotor is to be set in a specific operation mode of the servomotor. Thus, for example, an external trigger to start measuring the state of the servomotor may be input into a servo driver in the specific mode. To implement this structure, the servo driver is to have an input terminal for an external trigger and also to modify a program for, for example, a PLC that starts processing in response to the external trigger. This places a large barrier to implementing the structure using an external trigger. This issue is not limited to a servomotor, and can also occur in monitoring, for example, an electric motor including a servomotor and an induction motor, various devices associated with an electric motor, and devices used in work such as farming.

A technique according to an aspect of the disclosure is directed to a monitoring apparatus for an electric motor that can start measuring a parameter indicating the state of the electric motor as a monitoring target device in an intended operating state without relying on an external trigger.

### SOLUTION TO PROBLEM

A technique according to an aspect of the disclosure may be a monitoring apparatus described below. The monitoring apparatus includes a storage that stores a trigger range usable to determine whether measurement of a parameter indicating a state of a monitoring target device is to be started, a calculator that calculates a parameter associated with an operating state of the monitoring target device, and a measurer that starts measuring the parameter indicating the state of the monitoring target device in response to the parameter calculated by the calculator falling within the trigger range.

In response to the parameter associated with the operating state of the monitoring target device falling within the trigger range, the measurer starts measurement. This allows the measurer to start measurement in an intended operating state of the monitoring target device. More specifically, the monitoring apparatus can start measuring the parameter indicating the state of the monitoring target device in the intended operating state without relying on an external trigger.

For the monitoring target device including an electric motor, the parameter may be at least one selected from the group consisting of a temperature of the electric motor, a rate of change of the temperature of the electric motor, a temperature difference between the temperature of the electric motor and a temperature in a room in which the electric motor is installed, an acceleration of the electric motor, and a speed of the electric motor. The physical quantities listed in the group are each an example of the parameter associated with the operating state of the electric motor. For example, the temperature of the electric motor is a physical quantity associated with loss in the electric motor.

The monitoring apparatus may also have the features described below. The calculator calculates two or more types of parameters associated with the operating state of the monitoring target device, generates a histogram indicating an occurrence of a combination of the two or more types of parameters calculated at the same time, and stores the generated histogram into the storage. The monitoring apparatus further includes a setting unit that sets the trigger range based on the histogram. The monitoring apparatus with these features can reduce the storage capacity of the storage for storing two or more types of parameters.

The monitoring apparatus may also have the features described below. The setting unit outputs the histogram to a display and sets a selected range in the output histogram as the trigger range. The monitoring apparatus with these features can set the range intended by the user of the monitoring target device as the trigger range.

The monitoring apparatus may also have the features described below. The calculator excludes a combination with at least one of the two or more types of parameters being less than or equal to a threshold indicating the monitoring target device being stopped to generate the histogram. The monitoring apparatus with these features can reduce the likelihood that the measurer starts measurement when the monitoring target device is stopped.

The monitoring apparatus may also have the features described below. The monitoring target device includes an electric motor. The calculator further calculates a rate of change of a frequency of alternating current to drive the electric motor. The setting unit sets, in the histogram, an area with the rate of change within a predetermined range indicating the electric motor operating steadily as the trigger range. The monitoring apparatus with these features can more accurately measure the parameter indicating the state of the electric motor to be measured in a steady operating state.

The monitoring apparatus may also have the features described below. The monitoring apparatus further includes a notifier that provides a notification of the parameter indicating the state of the monitoring target device measured by the measurer. The monitoring apparatus with these features can provide a notification of the state of the monitoring target device in an intended operating state.

### ADVANTAGEOUS EFFECTS

The technique according to the aspects of the disclosure can start measuring the parameter indicating the state of the monitoring target device in an intended operating state without relying on an external trigger.

### BRIEF DESCRIPTION OF THE DRAWINGS

FIG. 1 is a schematic diagram of a servo system according to an embodiment.
FIG. 2 is a schematic block diagram of a motor.
FIG. 3 is a schematic functional block diagram of a servo driver.
FIG. 4 is a schematic diagram describing the value of a current supplied to the motor.
FIG. 5 is a schematic diagram describing a harmonic content measured by a monitoring apparatus in a normal operation of the motor.
FIG. 6 is a schematic diagram describing a harmonic content measured by the monitoring apparatus when the motor has an abnormality.
FIG. 7 is a schematic functional block diagram of the monitoring apparatus.
FIG. 8 is a schematic diagram describing a current amplitude calculated by a calculator.
FIG. 9 is a schematic diagram describing a frequency calculated by the calculator.
FIG. 10 is a schematic diagram describing the current amplitude and the frequency calculated by the calculator.
FIG. 11 is a graph showing example time-series data about a current amplitude calculated by the calculator.
FIG. 12 is a graph showing example time-series data about a frequency calculated by the calculator.
FIG. 13 is a diagram showing an example histogram generated by the calculator.
FIG. 14 is a schematic diagram showing an area set as a trigger on the histogram.
FIG. 15 is a flowchart of an example process for setting ranges of current amplitude and frequency performed by a setting unit.
FIG. 16 is a flowchart of an example process for detecting an abnormality in the motor performed by the monitoring apparatus.
FIG. 17 is a flowchart of another example process for detecting an abnormality in the motor performed by the monitoring apparatus.
FIG. 18 is a schematic diagram showing an area set as the trigger on a three-dimensional histogram in a first modification.
FIG. 19 is a schematic diagram of a servo system according to a second modification.
FIG. 20 is a schematic functional block diagram of a monitoring apparatus according to the second modification.
FIG. 21 is a flowchart of an example process for setting ranges of temperature and the rate of change of the temperature performed by the setting unit in the second modification.
FIG. 22 is a flowchart of an example process for measuring a parameter indicating the state of the motor performed by the monitoring apparatus according to the second modification.
FIG. 23 is a flowchart of another example process for measuring the parameter indicating the state of the motor performed by the monitoring apparatus according to the second modification.

### DETAILED DESCRIPTION

### Embodiments

One or more embodiments of the present invention will now be described in detail with reference to the drawings. The same reference numerals denote the same or corresponding components in the drawings, and such components will not be described repeatedly. An industrial system is used as an example of a servo system according to one or more embodiments of the present disclosure. However, the servo system according to one or more embodiments of the present disclosure may be used as any other system.

### Embodiments

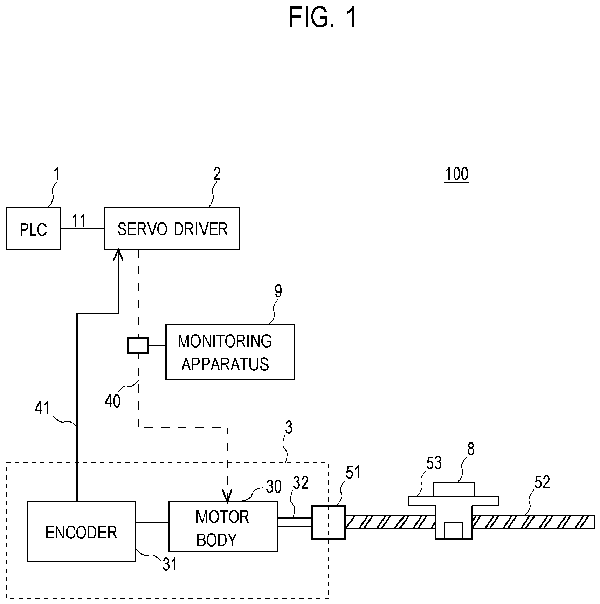

FIG. 1 is a schematic diagram of a servo system 100 according to an embodiment. The servo system 100 includes a programmable logic controller (PLC) 1, a servo driver 2, and a monitoring apparatus 9. The servo driver 2 is installed to drive and control a servomotor 3. The servomotor 3 includes an output shaft 32 connected to a screw shaft 52 with a coupling 51. A precision stage 53 is located on the screw shaft 52. The precision stage 53 is moved on the screw shaft 52 as the servomotor (hereafter, a motor) 3 is driven.

Stoppers (not shown) are located at both ends of the drivable range of the precision stage 53 along the screw shaft 52. The motor 3 has its torque controlled to minimize the impact caused by the precision stage 53 coming in contact with the stoppers. The precision stage 53 receives a workpiece 8. As describe above, the servo system 100 shown in FIG. 1 includes one drive shaft drivable by the motor 3. The servo system 100 may include two or more drive shafts.

The PLC 1 outputs a command signal to the servo driver 2. The PLC 1 performs a process in accordance with a predetermined program and functions as, for example, a monitoring apparatus for the servo driver 2.

The servo driver 2 receives a command signal from the PLC 1. The servo driver 2 also receives a feedback signal from the motor 3. The servo driver 2 includes a servo system for feedback control using, for example, a position controller, a speed controller, and a current controller. The servo driver 2 performs servo control over the motor 3 to drive the motor 3 using signals from these controllers.

The motor 3 includes a motor body 30 and an encoder 31. The motor 3 is, for example, an alternating current (AC) servomotor. The motor 3 receives a driving current from the servo driver 2 through a power line 40. The encoder 31 detects a displacement of the output shaft 32 in the motor body 30. Examples of the displacement of the output shaft 32 detected by the encoder 31 include the rotation direction, the rotation amount, and the rotational speed of the output shaft 32. The encoder 31 outputs a feedback signal indicating the detected displacement to the servo driver 2 through an encoder cable 41. The monitoring apparatus 9 for monitoring the motor 3 is connected to the power line 40. The driving current is an example of alternating current.

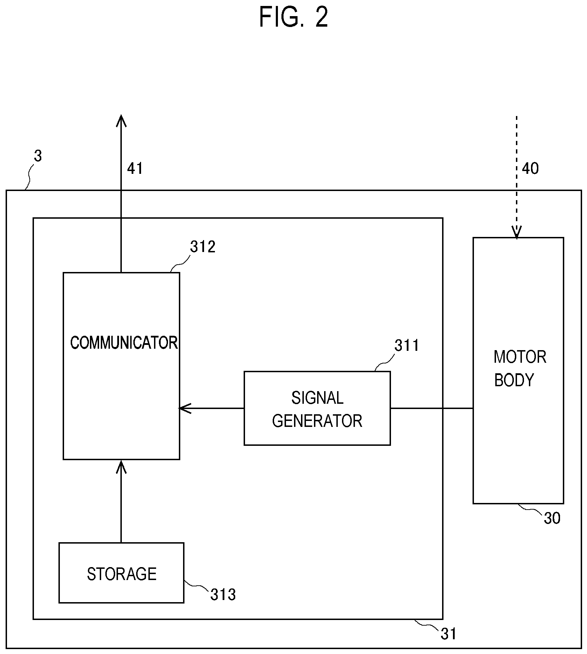

The functional components of the encoder 31 will now be described. FIG. 2 is a schematic block diagram of the motor 3. The encoder 31 in the motor 3 includes a signal generator 311, a communicator 312, and a storage 313.

The signal generator 311 detects a motion of the motor body 30 of the motor 3 driven by the servo driver 2 and generates a feedback signal indicating the detected motion. The feedback signal is output to the communicator 312. The feedback signal includes, for example, information about the rotational position (angle) of the rotation shaft of the motor body 30, information about the rotational speed of the rotation shaft, and information about the rotation direction of the rotation shaft. The structure of the signal generator 311 may be, for example, the structure of a known incremental or absolute encoder.

The communicator 312 is an interface for communicating with the servo driver 2. The communicator 312 in the present embodiment transmits a feedback signal to the servo driver 2 through the encoder cable 41. In the present embodiment, the communicator 312 transmits a feedback signal and a detection signal using serial communication. This reduces the number of signal lines included in the cable. A known communication standard such as Recommended Standard (RS) 232 (RS-232C), RS-422, or RS-485 may be used for serial communication through the encoder cable 41.

The storage 313 stores data about servo control over the motor 3. The storage 313 is, for example, an electrically erasable programmable read-only memory (EEPROM). The motor 3 is an example of a monitoring target device.

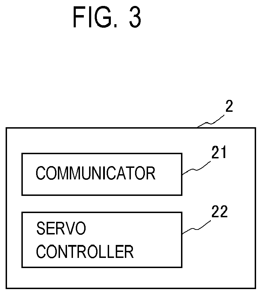

The servo driver 2 performs servo control over the motor 3 to drive the motor 3. FIG. 3 is a schematic functional block diagram of the servo driver 2. The servo driver 2 can be a computer including, for example, an arithmetic unit and a storage device. The functional units shown in FIG. 3 are implemented by the servo driver 2 executing, for example, predetermined programs. The servo driver 2 includes a communicator 21 and a servo controller 22. The servo driver 2 may include other functional unis.

The communicator 21 is a functional unit for performing communication with an external device through a communication cable 11. For example, the communicator 21 functions as an interface for communication with the PLC 1. The communicator 21 also functions as an interface for communication with the encoder 31 through the encoder cable 41.

The servo controller 22 is a functional unit for servo control over the motor 3 based on a command from the PLC 1, more specifically, for feedback control using, for example, the position controller, the speed controller, and the current controller. Control parameters such as speed gain are set as appropriate for the position controller, the speed controller, and the current controller to perform appropriate servo control over the motor 3 as a control target. The servo controller 22 switches the operation mode of the motor 3 as appropriate for, for example, the workpiece 8 placed on the precision stage 53.

The monitoring apparatus 9 monitors the motor 3 under servo control driven by the servo driver 2 and detects any abnormality in the motor 3. The parameter used for such abnormality detection may be a harmonic content, an average value, or an effective value of a current supplied to the motor 3. In the present embodiment, the monitoring apparatus 9 uses the harmonic content of a current supplied to the motor 3 to detect an abnormality in the motor 3.

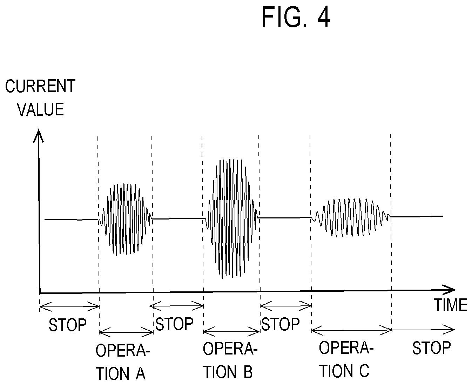

FIG. 4 is a schematic diagram describing the value of a current supplied to the motor 3. In the example of FIG. 4, the operational mode is switched to an operation A, an operation B, an operation C, or stop under servo control performed by the servo driver 2. As shown in FIG. 4, the value of the current supplied to the motor 3 largely changes each time the operation mode is switched. In this example, the workpiece 8 is placed on the precision stage 53 during the operation B and transported as the motor 3 is driven. A user of the servo system 100 intends to detect an abnormality in the motor 3 while the workpiece 8 is being transported.

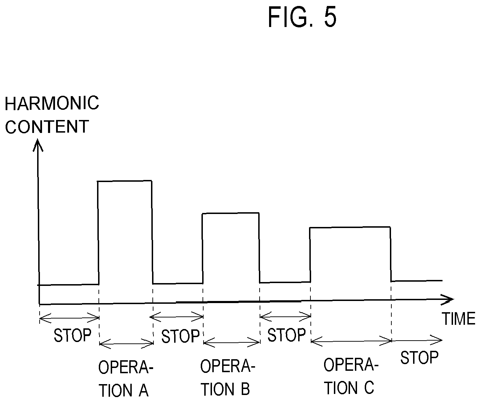

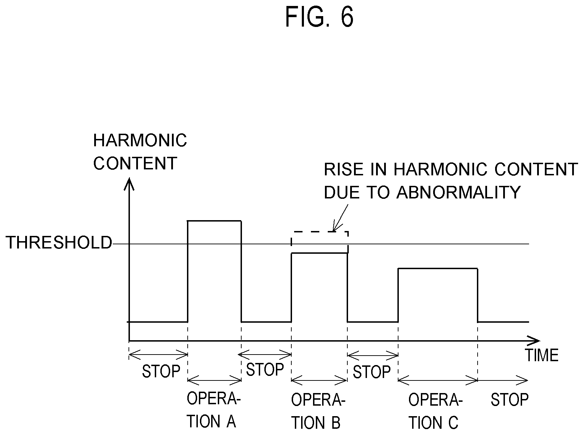

FIG. 5 is a schematic diagram describing a harmonic content measured by the monitoring apparatus 9 in a normal operation of the motor 3. FIG. 6 is a schematic diagram describing a harmonic content measured by the monitoring apparatus 9 when the motor 3 has an abnormality. In the example of FIG. 6, the abnormality occurs in the motor 3 during the operation B. FIG. 6 also shows an example threshold set to detect an abnormality in the motor 3 during the operation B. In this example, the threshold is set less than the harmonic content during the operation A.

In FIG. 6, the harmonic content during the operation B is greater than the threshold due to the abnormality. However, in the example of FIG. 6, the difference between the harmonic content during the operation A and the harmonic content during the operation B is larger than the change in the harmonic content resulting from the abnormality during the operation B.

In this case, abnormality detection performed using the single threshold set as shown in FIG. 6 can detect an abnormality occurring during the operation B, but can also erroneously detect an abnormality during the operation A when no such abnormality is in the operation. To reduce the likelihood of such erroneous detection, the monitoring apparatus 9 according to the present embodiment has the structure described below.

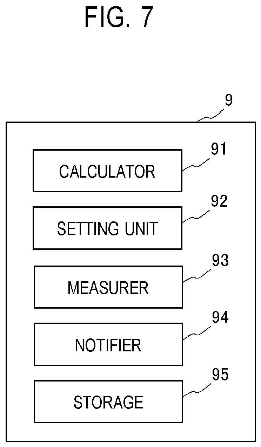

FIG. 7 is a schematic functional block diagram of the monitoring apparatus 9. The monitoring apparatus 9 can be a computer including, for example, an arithmetic unit and a storage device. The functional units shown in FIG. 7 are implemented by the monitoring apparatus 9 executing, for example, predetermined programs. The monitoring apparatus 9 includes a calculator 91, a setting unit 92, a measurer 93, a notifier 94, and a storage 95. The monitoring apparatus 9 may include other functional units.

The calculator 91 is a functional unit for calculating the current amplitude and the frequency of a driving current supplied to the motor 3. The frequency can be calculated from, for example, a current waveform. The calculator 91 may, for example, detect a zero crossing point of the current waveform and calculate the frequency based on the time taken to the next zero crossing point. The current amplitude and the frequency calculated by the calculator 91 are used to set, for example, a trigger to cause the measurer 93 to start measurement. The current amplitude of a driving current is a parameter associated with the torque of the motor 3. The frequency of a driving current is a parameter associated with the rotational speed of the motor 3.

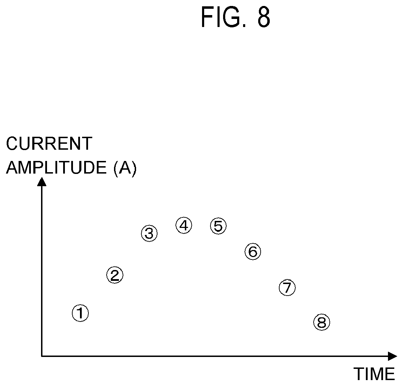

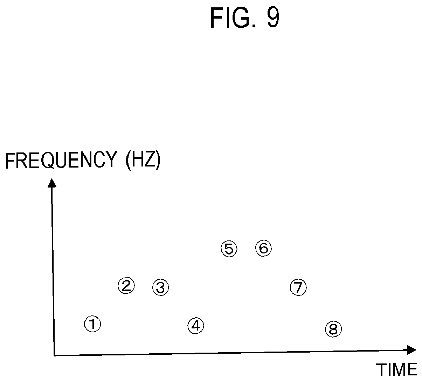

The calculator 91 also calculates the occurrence of the current amplitude and the frequency of a driving current supplied to the motor 3 calculated at the same time. FIGs. 8 to 10 are schematic diagrams describing calculation of the occurrence of pairs of current amplitude and frequency performed by the calculator 91. FIG. 8 is a schematic diagram describing the current amplitude calculated by the calculator 91. In FIG. 8, the vertical axis indicates current amplitude, and the horizontal axis indicates time. FIG. 9 is a schematic diagram describing the frequency calculated by the calculator 91. In FIG. 9, the vertical axis indicates frequency, and the horizontal axis indicates time. In FIGs. 8 and 9, the current amplitude and the frequency calculated at the same time are associated with each other with the same circled number. For example, the current amplitude indicated by the circled 3 in FIG. 8 and the frequency indicated by the circled 3 in FIG. 9 are the values calculated at the same time.

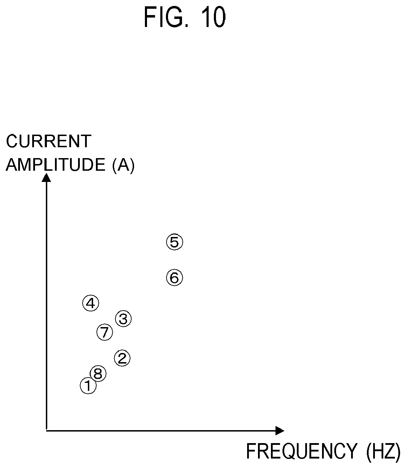

FIG. 10 is a schematic diagram describing the current amplitude and the frequency calculated by the calculator 91. In FIG. 10, the vertical axis indicates current amplitude, and the horizontal axis indicates frequency. In FIG. 10, pairs of current amplitude and frequency are plotted on the graph. The current amplitude and the frequency in each pair are the values calculated at the same time. The pairs of current amplitude and frequency are plotted in a space defined by one axis indicating the current amplitude and the other axis indicating the frequency to facilitate understanding of types of pairs that occur frequently.

In the example described below based on the above, the calculator 91 calculates the occurrence of a pair of current amplitude and frequency calculated at the same time. The calculator 91 calculates the current amplitude and the frequency of a driving current for a predetermined learning period. The calculator 91 calculates the current amplitude and the frequency of a driving current for each operation mode of the motor 3 switched by the servo driver 2.

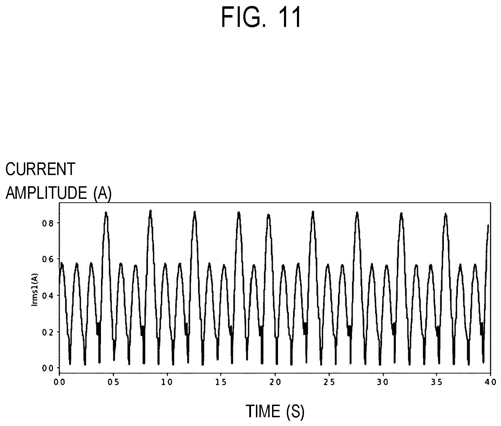

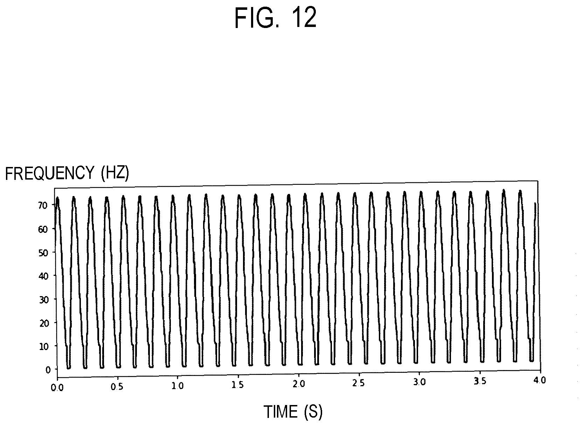

FIG. 11 is a graph showing example time-series data about the current amplitude calculated by the calculator 91. In FIG. 11, the vertical axis indicates current amplitude (A), and the horizontal axis indicates time (second). FIG. 12 is a graph showing example time-series data about the frequency calculated by the calculator 91. In FIG. 12, the vertical axis indicates frequency (Hz), and the horizontal axis indicates time (second).

The calculator 91 calculates the occurrence of each pair of current amplitude and frequency calculated at the same time based on time-series data about the calculated current amplitude and time-series data about the calculated frequency. The calculator 91 may store the occurrence of each of all pairs of the calculated current amplitude and frequency into the storage 95. When the occurrence of each of all pairs of the calculated current amplitude and frequency are to be stored into the storage 95, a larger amount of data is stored into the storage 95. The storage 95 is thus to have a large storage capacity or to transfer the data to a host device. To reduce the amount of data stored into the storage 95, the calculator 91 generates a two-dimensional histogram indicating the occurrence of the pairs described above based on the collected data.

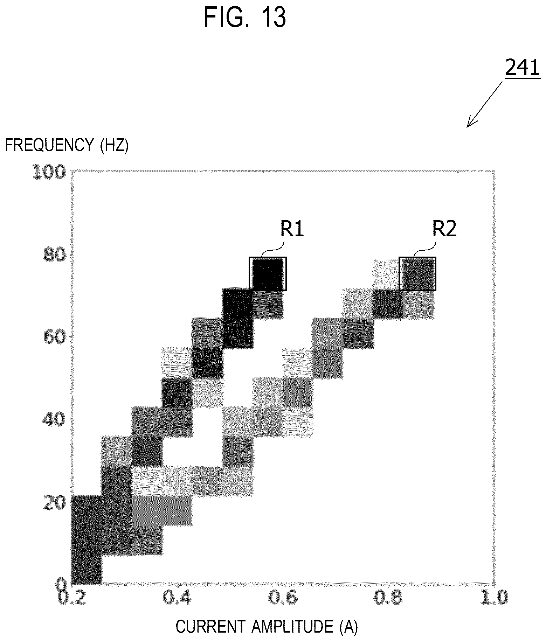

FIG. 13 is a diagram showing an example histogram 241 generated by the calculator 91. In FIG. 13, the vertical axis indicates frequency, and the horizontal axis indicates current amplitude. In the histogram 241, multiple areas are defined by dividing the current amplitude and the frequency at predetermined intervals. Each of the defined areas includes pairs of current amplitude and frequency. Color shading in each defined area indicates the occurrence of the pairs of current amplitude and frequency associated with the area. A darker color indicates a higher occurrence. The occurrence of the pairs of current amplitude and frequency is stored into the storage 95 as the histogram 241 to reduce the storage capacity for storing the occurrence of the pairs of current amplitude and frequency to a size obtained by multiplying the number of predetermined intervals for the current amplitude by the number of predetermined intervals for the frequency. Each of the current amplitude and the frequency is an example of a parameter associated with the operating state of the monitoring target device. A pair of current amplitude and frequency is an example of a combination of two or more types of parameters.

The calculator 91 may exclude, from the histogram 241, a pair of calculated current amplitude and frequency with at least one of the current amplitude or the frequency being less than or equal to a predetermined value indicating the motor 3 being stopped. More specifically, the calculator 91 may exclude a pair of calculated current amplitude and frequency with at least one of at least one of the current amplitude or the frequency being less than or equal to the predetermined value indicating the motor 3 being stopped to generate the histogram 241.

The setting unit 92 sets a trigger to cause the measurer 93 to start measurement. The setting unit 92 may set, for example, an area satisfying a predetermined trigger setting condition as a trigger in the histogram 241. The trigger setting condition includes, for example, an area including a current amplitude and a frequency with the occurrence being 5% or greater of all the data in the histogram 241. An area R1 in FIG. 13 is an example area that satisfies such a trigger setting condition in the histogram 241. This trigger setting condition allows the trigger to be set as the operating state of the motor 3 that occurs most frequently. The area R1 in FIG. 13 is an example of a trigger range. For example, in response to the current amplitude and the frequency calculated by the calculator 91 falling within the trigger range, the measurer 93 (described later) starts measurement. More specifically, the trigger range is used to determine whether the measurer 93 can start measurement.

The trigger setting condition may include, for example, an area including the highest frequency of the areas with the occurrence greater than or equal to a predetermined value in the histogram 241. In the example of FIG. 13, the area R1 in FIG. 13 is also an example area that satisfies such a trigger setting condition. This trigger setting condition allows the trigger to be set as the occurrence being high and the rotation frequency of the motor 3 being high.

The trigger setting condition may also include, in the histogram 241, an area including the largest current amplitude of the areas with the occurrence greater than or equal to the predetermined value. An area R2 in FIG. 13 is an example area that satisfies such a trigger setting condition in the histogram 241. This trigger setting condition allows the trigger to be set as the occurrence being high and the torque of the motor 3 being high.

The setting unit 92 may display the histogram 241 on, for example, a display for the user to select an area to be set as the trigger. The frequency and the current amplitude can change in accordance with the operation mode of the motor 3. To detect an abnormality in the motor 3 during, for example, the operation B (refer to FIG. 4), the area corresponding to the operation B may be selected on the histogram 241.

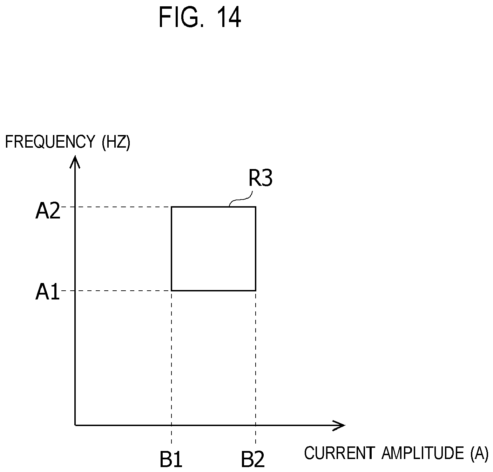

The setting unit 92 then stores the set trigger into the storage 95. FIG. 14 is a schematic diagram showing an area set as the trigger on the histogram 241. In FIG. 14, the vertical axis indicates frequency, and the horizontal axis indicates current amplitude. FIG. 14 shows an area R3 set as the trigger. The area R3 is a rectangle with the frequency ranging from A1 to A2 inclusive and the current amplitude ranging from B1 to B2 inclusive. With the area R3 set as the trigger, the measurer 93 (described later) starts measurement when the frequency calculated by the calculator 91 is higher than or equal to the frequency A1 and lower than or equal to the frequency A2, and the current amplitude calculated by the calculator 91 is higher than or equal to the frequency B1 and lower than or equal to the frequency B2.

The measurer 93 performs measurement to detect an abnormality in the motor 3 when the current amplitude and the frequency calculated by the calculator 91 fall within the area set as the trigger by the setting unit 92. The measurer 93 measures, for example, the harmonic content in the waveform of the current supplied to the motor 3. The measurer 93 performs, for example, a fast Fourier transform (FFT) on the waveform of the current supplied to the motor 3 to obtain its fundamental and n-th harmonic (n is an integer greater than or equal to 2). The measurer 93 then calculates the percentage of the second or higher harmonic to the fundamental to measure the harmonic content. The harmonic content is an example of a parameter indicating the state of the monitoring target device.

When the harmonic content measured by the measurer 93 exceeds the threshold stored in the storage 95, the notifier 94 provides a notification of an abnormality. The notification of the abnormality may be provided by, for example, outputting an alarm sound, outputting a warning message to the display, or sending an email.

The storage 95 is, for example, an EEPROM. The storage 95 stores the trigger set by the setting unit 92 and the threshold used by the notifier 94. The storage 95 may also store a measurement time to be taken by the measurer 93 to perform measurement. The monitoring apparatus 9 is an example of a monitoring apparatus.

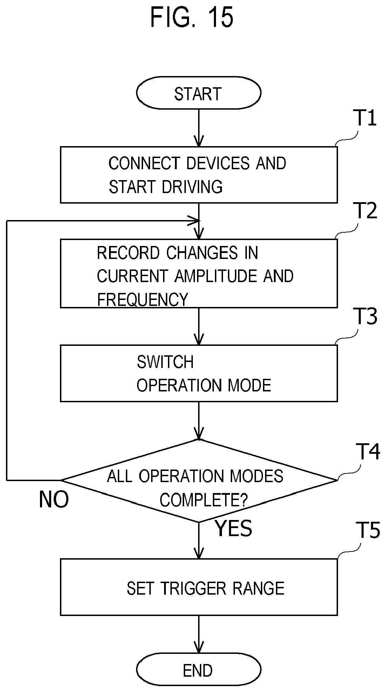

FIG. 15 is a flowchart of an example process for setting ranges of current amplitude and frequency performed by the setting unit 92. The example process for setting the ranges of current amplitude and frequency performed by the setting unit 92 will now be described with reference to FIG. 15.

In step T1, the PLC 1, the servo driver 2, and the motor 3 are connected to form the servo system 100. The servo controller 22 in the servo driver 2 starts driving the motor 3 in a predetermined operation mode (e.g., the operation A in FIG. 4) in response to a command signal from the PLC 1.

In step T2, the calculator 91 in the monitoring apparatus 9 calculates the current amplitude and the frequency of a driving current supplied to the motor 3. The calculator 91 continuously calculates the current amplitude and the frequency of the driving current supplied to the motor 3 for a predetermined period. The calculator 91 also calculates the occurrence of each pair of current amplitude and frequency calculated at the same time.

In step T3, the servo controller 22 in the servo driver 2 switches the operation mode of the motor 3. When the motor 3 is being driven in, for example, the operation A, the servo controller 22 may change the operation mode to the operation B to drive the motor 3. When the current amplitude and the frequency of the driving current supplied to the motor 3 are recorded for all the operation modes of the motor 3 (Yes in step T4), the processing advances to step T5. When the current amplitude and the frequency of the driving current supplied to the motor 3 are yet to be recorded for all the operation modes of the motor 3 (No in step T4), the processing returns to step T2.

In step T5, the setting unit 92 in the monitoring apparatus 9 sets a trigger. The setting unit 92 may calculate a histogram 241 based on the current amplitude and the frequency calculated by the calculator 91 in step T2 and set, in the histogram 241, an area that satisfies a predetermined trigger setting condition as the trigger. The setting unit 92 may display the histogram 241 on, for example, the display for the user to select an area to be set as the trigger.

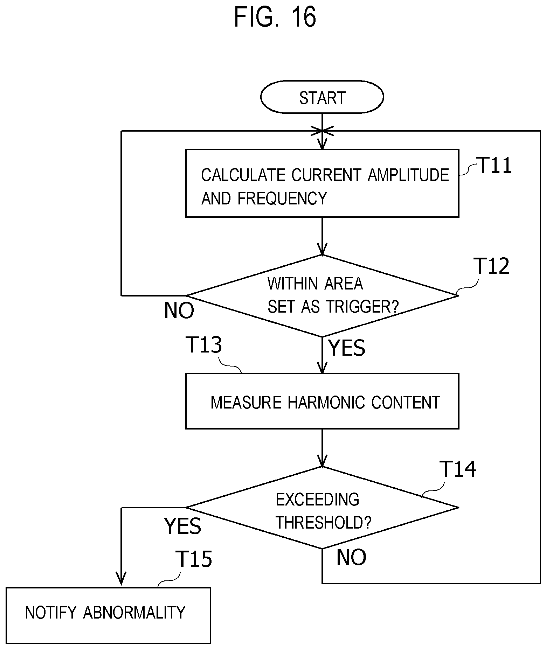

FIG. 16 is a flowchart of an example process for detecting an abnormality in the motor 3 performed by the monitoring apparatus 9. In the example described below with reference to FIG. 16, the measurement is continuously performed by the measurer 93 when the current amplitude and the frequency calculated by the calculator 91 remain within the area set as the trigger. An example process for detecting an abnormality in the motor 3 performed by the monitoring apparatus 9 will now be described with reference to FIG. 16.

In step T11, the calculator 91 calculates the current amplitude and the frequency of a driving current supplied to the motor 3. When the calculated current amplitude and frequency fall within, for example, the area set as the trigger in step T5 in FIG. 15 (Yes in step T12), the processing advances to step T13. When the calculated current amplitude and frequency are outside, for example, the area set as the trigger in step T5 in FIG. 15 (No in step T12), the processing returns to step T11.

In step T13, the measurer 93 measures a harmonic content in the waveform of the current supplied to the motor 3. When the measured harmonic content exceeds a threshold stored in the storage 95 (Yes in step T14), the processing advances to step T15. When the measured harmonic content is less than or equal to the threshold stored in the storage 95 (No in step T14), the processing returns to step T11.

In step T15, the notifier 94 provides a notification indicating that an abnormality occurs in the motor 3.

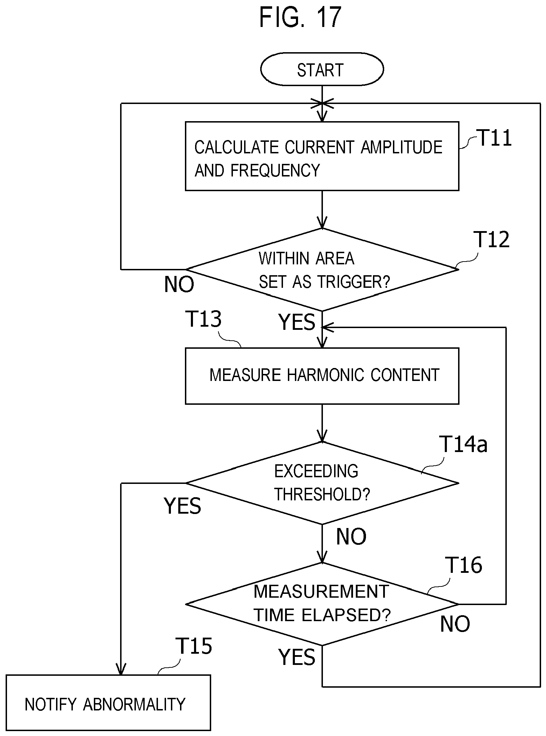

FIG. 17 is a flowchart of another example process for detecting an abnormality in the motor 3 performed by the monitoring apparatus 9. FIG. 17 shows the process for the measurement continuously performed by the measurer 93 for a predetermined period. The other example process for detecting an abnormality in the motor 3 performed by the monitoring apparatus 9 will now be described with reference to FIG. 17. The same reference numerals denote the same processes as in FIG. 16, and such processes will not be described.

In step T14a, when the harmonic content measured in step T13 exceeds the threshold stored in the storage 95 (Yes in step T14a), the processing advances to step T15. When the harmonic content measured in step T13 is less than or equal to the threshold stored in the storage 95 (No in step T14a), the processing advances to step T16.

In step T16, the measurer 93 determines whether the measurement time of the harmonic content has reached a measurement time stored in the storage 95. When the measurement time has elapsed (Yes in step T16), the processing returns to step T11. When the measurement time of the harmonic content has not elapsed (No in step T16), the processing returns to step T13.

### Operational Effects of Embodiment

In the present embodiment, an area is set as a trigger based on the current amplitude and the frequency of a driving current supplied to the motor 3 calculated in advance. The current amplitude of the driving current is associated with the torque of the motor 3. The frequency of the driving current is associated with the rotational speed of the motor 3. In the present embodiment, the trigger is set based on such current amplitude and frequency. Thus, the trigger can be set based on the current amplitude and the frequency associated with the operating state of the motor 3, without an externally input trigger to start measurement for abnormality detection. In the present embodiment, the motor 3 can be detected as being in an intended operation mode when the current amplitude and the frequency calculated by the calculator 91 fall within the area set as the trigger. In the present embodiment, the measurement to detect an abnormality in the motor 3 can be performed by measuring the harmonic content of the motor 3 indicating the state of the motor 3 in the intended operation mode.

In the present embodiment, the frequency and the current amplitude calculated by the calculator 91 are stored into the storage 95 as the histogram 241. This can reduce the storage capacity of the storage 95 for storing the frequency and the current amplitude in the present embodiment.

In the present embodiment, the setting unit 92 can also display the histogram 241 on, for example, the display for the user to select an area to be set as the trigger. This allows an area intended by the user to be set as the trigger in the present embodiment.

In the present embodiment, the calculator 91 can exclude a pair of calculated current amplitude and frequency with at least one of the current amplitude or the frequency being less than or equal to a predetermined value indicating the motor 3 being stopped to generate the histogram 241. In the present embodiment, the histogram 241 is generated in this manner, thus reducing the likelihood that the measurer 93 performs measurement when the motor 3 is stopped.

### First Modification

In the embodiment described above, the trigger to cause the measurer 93 to start measurement is set based on the pairs of current amplitude and frequency. In a first modification, the trigger to cause the measurer 93 to start measurement is set based on the rate of change of frequency in addition to the current amplitude and frequency.

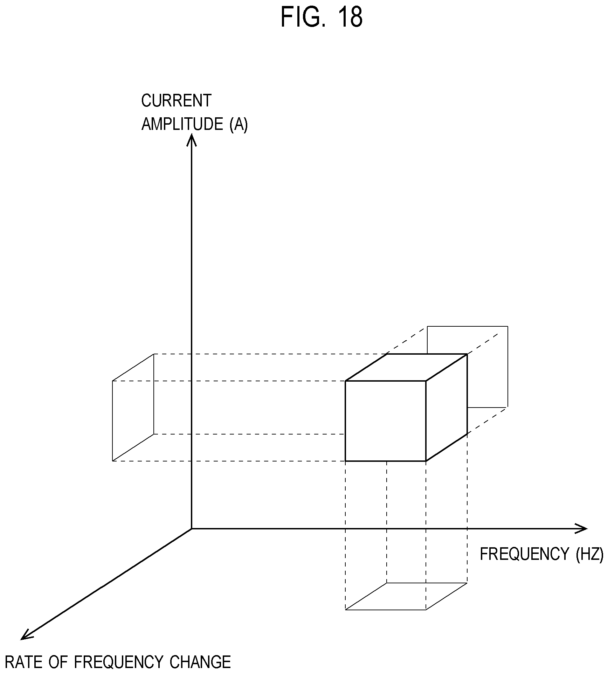

In the first modification, the calculator 91 may generate, instead of the histogram 241, a three-dimensional histogram including three orthogonal axes indicating the current amplitude, frequency, or rate of change of frequency. FIG. 18 is a schematic diagram showing an area set as a trigger on the three-dimensional histogram in the first modification. An area can also be set as the trigger based on a three-dimensional histogram including three parameters as in the first modification.

When the rate of change of frequency is included as a parameter for setting the trigger, an area with the rate of change of frequency close to 0 is to be selected as the trigger. The rate of change of frequency close to 0 may include, for example, the rate of change of frequency within a predetermined range from 0 to a value indicating no change in the rotational speed of the motor 3. The area with the rate of change of frequency close to 0 being selected as the trigger in the three-dimensional histogram allows the state in which the motor 3 operates steadily (operates at a substantially constant speed) to be a condition for the trigger.

The measurer 93 starts measurement based on the trigger set in this manner, thus allowing more accurate measurement of a parameter to be measured with the motor 3 operating steadily. Examples of the parameter to be measured with the motor 3 operating steadily include the harmonic content calculated by the FFT. More specifically, the harmonic content can be more accurately measured by setting the state in which the motor 3 operates steadily as the trigger.

### Second Modification

In the embodiment and the first modification described above, the current amplitude, frequency, and rate of change of frequency are used to set the trigger to start measurement to detect an abnormality in the motor 3. However, the parameters used as the trigger to start measurement are not limited to these, and various other parameters indicating the operating state of the motor 3 can be used as the trigger to start measurement. The monitoring apparatus 9 may not only detect an abnormality in the motor 3, but also measure parameters indicating various states of the motor 3. In a second modification, the temperature of the motor 3 and the rate of change of the temperature of the motor 3 are used to set the trigger to start measurement of a parameter indicating the state of the motor 3.

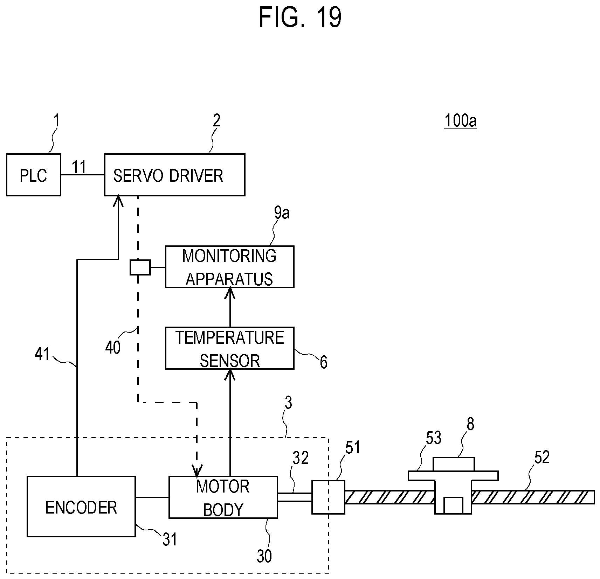

FIG. 19 is a schematic diagram of a servo system 100a according to the second modification. The servo system 100a further includes a temperature sensor 6 for measuring the temperature of the motor 3, and also includes a monitoring apparatus 9a instead of the monitoring apparatus 9. The monitoring apparatus 9a is connected to the temperature sensor 6 and obtains the temperature of the motor 3 measured by the temperature sensor 6. The temperature is an example of a physical quantity indicating loss in the motor 3. The monitoring apparatus 9a monitors the temperature and the rate of change of the temperature of the motor 3 that is controlled by servo control and driven by the servo driver 2 and starts measuring the parameter indicating the state of the motor 3 in an intended operating state.

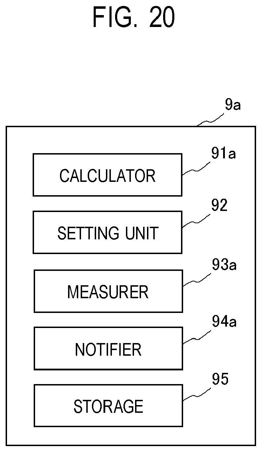

FIG. 20 is a schematic functional block diagram of the monitoring apparatus 9a according to the second modification. The monitoring apparatus 9a includes a calculator 91a, the setting unit 92, a measurer 93a, a notifier 94a, and the storage 95.

The calculator 91a is a functional unit for obtaining the temperature of the motor 3 and also calculating the rate of change of the temperature of the motor 3. The calculator 91a stores the temperature of the motor 3 obtained from the temperature sensor 6 into the storage 95. The calculator 91a calculates the rate of change of the temperature of the motor 3 from the rate of change of the temperature stored in the storage 95 with respect to time. The calculator 91a also calculates the occurrence of each pair of the temperature of the motor 3 and the rate of change of the temperature of the motor 3 in the same manner as the calculator 91. The calculator 91a then generates, in the same manner as the calculator 91, a two-dimensional histogram indicating the occurrence of each pair of the temperature of the motor 3 and the rate of change of the temperature of the motor 3 and stores the generated histogram into the storage 95. The temperature of the motor 3 and the rate of change of the temperature of the motor 3 are each an example of the parameter. A pair of the temperature of the motor 3 and the rate of change of the temperature of the motor 3 is an example of a combination of two or more types of parameters.

When the temperature of the motor 3 obtained by the calculator 91a and the rate of change of the temperature of the motor 3 calculated by the calculator 91a fall within an area set as the trigger by the setting unit 92, the measurer 93a starts measuring the parameter indicating the state of the motor 3. Examples of the parameter indicating the state of the motor 3 measured by the measurer 93a include the speed, the acceleration, and the torque of the motor 3.

The notifier 94a provides a notification of the state of the motor 3 measured by the measurer 93a. The notification may be provided by, for example, outputting a voice, outputting a message to the display, or sending an email. The notifier 94a may generate a graph showing the temperature of the motor 3 and the rate of change of the temperature of the motor 3 measured by the measurer 93a and display the generated graph on the display.

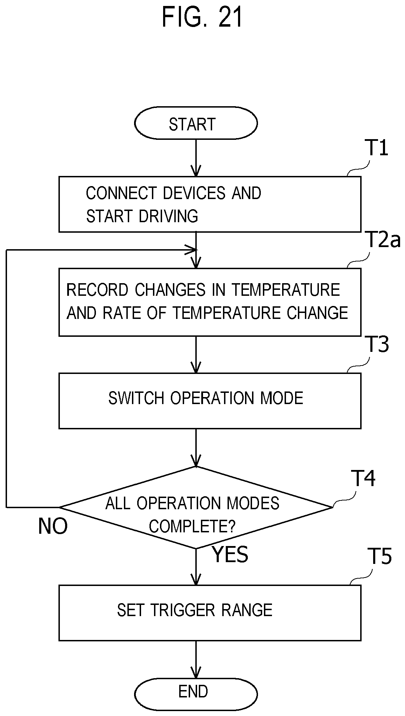

FIG. 21 is a flowchart of an example process for setting the ranges of the temperature and the rate of change of the temperature performed by the setting unit 92 in the second modification. The example process for setting the ranges of the temperature and the rate of change of the temperature performed by the setting unit 92 in the second modification will now be described with reference to FIG. 21. The same reference numerals denote the same processes as in FIG. 15, and such processes will not be described.

In step T2a, the calculator 91a in the monitoring apparatus 9a obtains the temperature of the motor 3 from the temperature sensor 6. The calculator 91a also calculates the rate of change of the temperature based on the temperature obtained from the temperature sensor 6. The calculator 91a continuously calculates the temperature and the rate of change of the temperature of the motor 3 for a predetermined period. The calculator 91a also calculates the occurrence of each pair of the temperature and the rate of change of the temperature calculated at the same time.

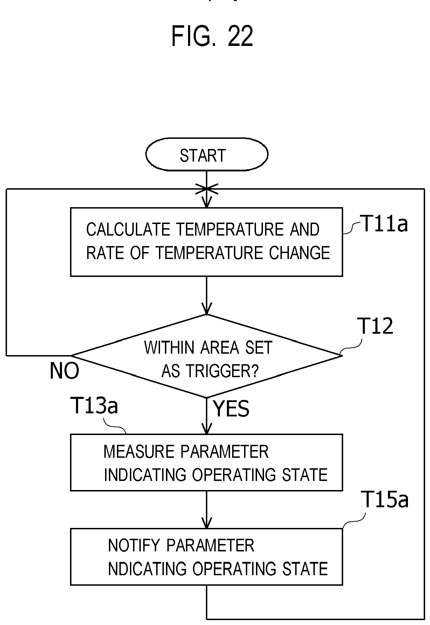

FIG. 22 is a flowchart of an example process for measuring a parameter indicating the state of the motor 3 performed by the monitoring apparatus 9a according to the second modification. In the example described below with reference to FIG. 22, the measurement is continuously performed by the measurer 93a when the temperature and the rate of change of the temperature calculated by the calculator 91a remain within the area set as the trigger. The example process for measuring the parameter indicating the state of the motor 3 performed by the monitoring apparatus 9a will now be described with reference to FIG. 22. The same reference numerals denote the same processes as in FIG. 16, and such processes will not be described.

In step T11a, the calculator 91 calculates the temperature and the rate of change of the temperature of the motor 3. When the calculated temperature and the calculated rate of change of the temperature fall within, for example, the area set as the trigger in step T5 in FIG. 21 (Yes in step T12), the processing advances to step T13a. When the calculated temperature and the calculated rate of change of the temperature are outside, for example, the area set as the trigger in step T5 in FIG. 21 (No in step T12), the processing returns to step T11a.

In step T13a, the measurer 93a measures the parameter indicating the state of the motor 3. In step T15a, the notifier 94a provides a notification of the state of the motor 3 measured in step T13a.

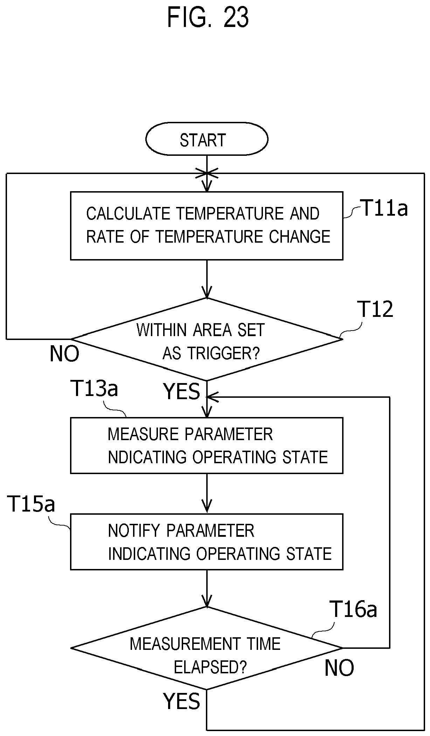

FIG. 23 is a flowchart of another example process for measuring the parameter indicating the state of the motor 3 performed by the monitoring apparatus 9a according to the second modification. FIG. 23 shows the process for the measurement continuously performed by the measurer 93a for a predetermined period. The other example process for measuring the parameter indicating the state of the motor 3 performed by the monitoring apparatus 9a will now be described with reference to FIG. 23. The same reference numerals denote the same processes as in FIG. 22, and such processes will not be described.

In step T16a, the measurer 93a determines whether the measurement time of the parameter indicating the state of the motor 3 has reached a measurement time stored in the storage 95. When the measurement time has elapsed (Yes in step T16a), the processing returns to step T11a. When the measurement time has not elapsed (No in step T16a), the processing returns to step T13a.

In the second modification, the parameter indicating the state of the motor 3 starts being measured in an intended operating state of the motor 3. Although the temperature of the motor 3 and the rate of change of the temperature of the motor 3 are each used as the parameter indicating the operating state of the motor 3 in the second modification, the parameter indicating the operating state of the motor 3 is not limited to these. Examples of the parameter indicating the operating state of the motor 3 include the temperature difference between the temperature of the motor 3 and the temperature in a room in which the motor 3 is installed, the acceleration of the motor 3, and the speed of the motor 3.

In the second modification, the notifier 94a can provide a notification of the state of the motor 3 in an intended operating state. In the second modification, the monitoring apparatus 9a can present the state of the motor 3 in the intended operating state to be easily understood visually by, for example, displaying the state of the motor 3 measured by the measurer 93a in a graph on the display.

The trigger to cause the measurer 93a to start measurement is set based on both the temperature and the rate of change of the temperature of the motor 3 in the second modification. The trigger to cause the measurer 93a to start measurement may be set based on at least one of the temperature or the rate of change of the temperature of the motor 3.

### Other modifications

Although the motor 3 is a servomotor in the above embodiment, the motor 3 is not limited to a servomotor. The motor 3 may be, for example, an induction motor. The motor 3 is not limited to an AC electric motor, and may be a direct current (DC) electric motor. Although the monitoring apparatus 9 monitors the motor 3 in the embodiment, the monitoring apparatus 9 may monitor a device other than the motor 3. Examples of the device monitored by the monitoring apparatus 9 include a pump for pumping a fluid, a boiler for producing water vapor and hot water, an air conditioner, a humidifier, and a greenhouse heater and a carbon dioxide generator used in farming.

Although the trigger to cause the measurer 93 to start measurement is set based on both the current amplitude and the frequency of a driving current supplied to the motor 3 in the above embodiment, the trigger to cause the measurer 93 to start measurement may be set based on at least one of the current amplitude or the frequency of the driving current.

Although the monitoring apparatus 9 is separate from the servo driver 2 in the above embodiment, the monitoring apparatus 9 may be incorporated in the servo driver 2.

The embodiment and the modifications described above may each be combined together.

### Appendix 1

A monitoring apparatus (9), comprising:
a storage (95) configured to store a trigger range usable to determine whether measurement of a parameter indicating a state of a monitoring target device (3) is to be started;
a calculator (91, 91a) configured to calculate a parameter associated with an operating state of the monitoring target device (3); and
a measurer (93, 93a) configured to start measuring the parameter indicating the state of the monitoring target device (3) in response to the parameter calculated by the calculator (91, 91a) falling within the trigger range.

### REFERENCE SIGNS LIST

- 1: programmable logic controller (PLC)
- 2: servo driver
- 3: motor
- 6: temperature sensor
- 8: workpiece
- 9: monitoring apparatus
- 9a: monitoring apparatus
- 21: communicator
- 22: servo controller
- 91: calculator
- 91a: calculator
- 92: setting unit
- 93: measurer
- 93a: measurer
- 94: notifier
- 94a: notifier
- 95: storage
- 30: motor body
- 31: encoder
- 241: histogram
- 311: signal generator
- 312: communicator
- 313: storage
- 32: output shaft
- 41: encoder cable
- 51: coupling
- 52: screw shaft
- 53: precision stage
- 100: servo system
- 100a: servo system

## Claims

1. A monitoring apparatus (9; 9a), comprising:
a storage (95) configured to store a trigger range usable to determine whether measurement of a parameter indicating a state of a monitoring target device (3) is to be started;
a calculator (91; 91a) configured to calculate a parameter associated with an operating state of the monitoring target device (3); and
a measurer (93; 93a) configured to start measuring the parameter indicating the state of the monitoring target device (3) in response to the parameter calculated by the calculator (91; 91a) falling within the trigger range.

2. The monitoring apparatus (9; 9a) according to claim 1, wherein
the calculator (91; 91a) calculates two or more types of parameters associated with the operating state of the monitoring target device (3), generates a histogram (241) indicating an occurrence of a combination of the two or more types of parameters calculated at the same time, and stores the generated histogram (241) into the storage (95), and
the monitoring apparatus (9; 9a) further comprises a setting unit (92) configured to set the trigger range based on the histogram (241).

3. The monitoring apparatus (9; 9a) according to claim 2, wherein
the setting unit (92) outputs the histogram (241) to a display and sets a selected range in the output histogram (241) as the trigger range.

4. The monitoring apparatus (9; 9a) according to claim 2 or claim 3, wherein
the calculator (91; 91a) excludes a combination with at least one of the two or more types of parameters being less than or equal to a threshold indicating the monitoring target device (3) being stopped to generate the histogram (241).

5. The monitoring apparatus (9; 9a) according to any one of claims 2 to 4, wherein
the monitoring target device (3) includes an electric motor (3),
the calculator (91; 91a) further calculates a rate of change of a frequency of alternating current to drive the electric motor (3), and
the setting unit (92) sets, in the histogram (241), an area with the rate of change within a predetermined range indicating the electric motor (3) operating steadily as the trigger range.

6. The monitoring apparatus (9; 9a) according to any one of claims 1 to 5, wherein
the monitoring target device (3) includes an electric motor (3), and
the parameter associated with the operating state is at least one selected from the group consisting of a temperature of the electric motor (3), a rate of change of the temperature of the electric motor (3), a temperature difference between the temperature of the electric motor (3) and a temperature in a room in which the electric motor (3) is installed, an acceleration of the electric motor (3), and a speed of the electric motor (3).

7. The monitoring apparatus (9; 9a) according to any one of claims 1 to 6, further comprising:
a notifier (94; 94a) configured to provide a notification of the parameter indicating the state of the monitoring target device (3) measured by the measurer (93; 93a).
